# EUROPEAN PATENT APPLICATION

(11) **EP 4 586 753 A1**
(43) Date of publication of application: **16.07.2025**
(21) Application number: 23869794.0
(22) Date of filing: 27.06.2023
(51) Int. Cl.: H05K 7/20, H02S 40/32, H02M 7/00, H02J 7/35

(54) **HEAT DISSIPATION APPARATUS, POWER DEVICE, AND PHOTOVOLTAIC SYSTEM**

(30) Priority: 28.09.2022 CN 202211193909
(71) Applicant: Huawei Digital Power Technologies Co., Ltd., Shenzhen, Guangdong 518043 (CN)
(72) Inventor: YUAN, Bo, Shenzhen, Guangdong 518043 (CN); SUN, Faming, Shenzhen, Guangdong 518043 (CN); WANG, Jiangang, Shenzhen, Guangdong 518043 (CN); LI, Maofan, Shenzhen, Guangdong 518043 (CN)
(74) Representative: Isarpatent
(86) International application number: PCT/CN2023/102936
(87) International publication number: WO 2024/066546

(57) **Abstract**

A heat dissipation apparatus (100), a power device, and a photovoltaic system are provided, to achieve good heat exchange effect. The heat dissipation apparatus (100) may include a housing (110). A heat source is fastened to an outer surface of a first side wall (1101) of the housing (110), or the first side wall (1101) of the housing (110) has an opening (1131a) and the heat source is fastened to an outer surface of a heat conduction substrate (1101b) embedded in the opening (1131a). A first partition plate (111) is disposed inside the housing (110). The first partition plate (111) partitions the housing (110) into a first cavity (112) and a second cavity (113). One or more channels (1111) are provided on the first partition plate (111). Each channel (1111) is configured to communicate the first cavity (112) with the second cavity (113). An end that is of each channel (1111) and that is close to the first side wall (1101) faces an area that is of the first side wall (1101) and to which the heat source is fastened or faces the heat conduction substrate (1101b).

## Description

### CROSS-REFERENCE TO RELATED APPLICATIONS

This application claims priority to Chinese Patent Application No. 202211193909.4, filed with the China National Intellectual Property Administration on September 28, 2022 and entitled "HEAT DISSIPATION APPARATUS, POWER DEVICE, AND PHOTOVOLTAIC SYSTEM", which is incorporated herein by reference in its entirety.

### TECHNICAL FIELD

This application relates to the field of heat dissipation technologies, and in particular, to a heat dissipation apparatus, a power device, and a photovoltaic system.

### BACKGROUND

Immersion liquid cooling is typical direct contact liquid cooling. A heat generation element is in direct contact with a refrigerant. Therefore, heat dissipation efficiency is high. Immersion liquid cooling is mainly classified into single-phase liquid cooling and two-phase liquid cooling. In single-phase liquid cooling, during circulation and heat dissipation, a coolant keeps being in a liquid state and does not undergo phase transition. In two-phase liquid cooling, a coolant undergoes phase transition during circulation and heat dissipation, and under impact of heat, the coolant in a liquid state undergoes phase transition and is gasified. As power of an inverter increases, a thermal power density of the inverter also rises; in this case, the inverter gradually uses two-phase liquid cooling for heat dissipation.

### SUMMARY

This application provides a heat dissipation apparatus, a power device, and a photovoltaic system, to achieve good heat exchange effect. Under a high heat load, the heat dissipation apparatus can also achieve good heat dissipation effect.

According to a first aspect, this application provides a heat dissipation apparatus. The heat dissipation apparatus may include a housing. A heat source is fastened to an outer surface of a first side wall of the housing, or the first side wall of the housing has an opening and the heat source is fastened to a heat conduction substrate embedded in the opening of the first side wall. An air outlet is provided on a second side wall of the housing. A liquid inlet is provided on a third side wall of the housing . A first partition plate is disposed inside the housing. One face of the first partition plate faces the first side wall, and the other face of the first partition plate is away from the first side wall. The first partition plate partitions the first housing into a first cavity and a second cavity. One or more channels are provided on the first partition plate. Each channel is configured to communicate the first cavity with the second cavity. An end that is of each channel and that is close to the first side wall faces an area that is of the first side wall and to which the heat source is fastened or faces the heat conduction substrate.

In this embodiment of this application, a refrigerant in a liquid state may enter the housing through the liquid inlet, and the refrigerant in a gas state may flow out of the housing through the air outlet. For ease of description, it is assumed that one of the first cavity and the second cavity that is close to the heat source is the first cavity, and a cavity that is away from the heat source is the second cavity. The refrigerant undergoes phase transition in the first cavity, and changes from the liquid state to the gas state. After gasification, the first cavity is in a low pressure state. The refrigerant in the liquid state in the second cavity flows into the first cavity through the channel on the first partition plate, to supplement the refrigerant in the liquid state in the first cavity. In addition, the channel faces the heat source, and the refrigerant in the liquid state is injected toward the heat source through the channel, so that a refrigerant at the heat source can be supplemented. This improves heat dissipation efficiency.

In a possible design, the opening is provided on the first side wall of the housing, and the heat conduction substrate embedded in the opening may carry the heat source. An inner peripheral wall of the opening of the first side wall is in a sealing fit with an outer peripheral wall of the heat conduction substrate, to avoid air leakage or liquid leakage at the opening.

In a possible design, a side that is of the first partition plate and that is close to the first side wall has one or more protrusion parts. At least one channel is provided on at least one protrusion part. A distance between the heat source and the channel on the protrusion part may be shortened by using the protrusion part, so that a refrigerant in the liquid state in the channel on the protrusion part can flow to the heat source more quickly.

In a possible design, the heat source includes at least one wafer. A projection of each wafer on the first partition plate (111) and each channel avoid each other. In a scenario in which the heat source includes the wafer, the wafer is usually a main heat generating component in the heat source. Each channel on the first partition plate and the wafer avoid each other, so that a refrigerant in the gas state at the heat source can be released more easily.

In a possible design, the second side wall and the third side wall are opposite to each other in a gravity direction, and the first side wall is located between the second side wall and the third side wall. In addition, the second side wall is located above the third side wall in the gravity direction, that is, the third side wall is located below the second side wall. Such a design facilitates disposing of a condenser at the top of the heat dissipation apparatus, and there may be no need to use a driving device, for example, a pump or a motor, to drive liquid to flow inside the heat dissipation apparatus or a gas to flow inside the heat dissipation apparatus.

In a possible design, a plurality of heat sources are fastened to the outer surface of the first side wall, and the plurality of heat sources are spaced from each other. One or more second partition plates are disposed inside a cavity between the first partition plate and the first side wall, and the second partition plate is configured to separate two adjacent heat sources, to prevent gases generated at the two adjacent heat sources from mingling with each other.

In some examples, the second side wall and the third side wall are opposite to each other in a gravity direction, and the first side wall is located between the second side wall and the third side wall. One surface of the at least one second partition plate faces the second side wall, and the other surface of the at least one second partition plate faces the third side wall.

In some examples, the second side wall and the third side wall are opposite to each other in the gravity direction, and the first side wall is located between the second side wall and the third side wall. A length direction of the at least one second partition plate is the gravity direction, a side wall of the at least one second partition plate is fastened to the first side wall, and a side wall opposite to the side wall extends toward the first partition plate.

In a possible design, the first side wall has a plurality of openings. At least one second partition plate is disposed inside a cavity between the first partition plate and the first side wall, and each second partition plate is configured to separate two adjacent openings, to prevent gases generated at two adjacent heat sources from mingling with each other.

In some examples, the second side wall and the third side wall are opposite to each other in a gravity direction, and the first side wall is located between the second side wall and the third side wall. One surface of the at least one second partition plate faces the second side wall, and the other surface of the at least one second partition plate faces the third side wall.

In some examples, the second side wall and the third side wall are opposite to each other in the gravity direction, and the first side wall is located between the second side wall and the third side wall. A length direction of the at least one second partition plate is the gravity direction, a side wall of the at least one second partition plate is fastened to the first side wall, and a side wall opposite to the side wall extends toward the first partition plate.

In a possible design, an end that is of the first partition plate and that is away from the air outlet is connected to the first side wall of the housing by using a third partition plate. One face of the third partition plate faces the second side wall, and the other face of the third partition plate faces the third side wall. The third partition plate may block an area between the first side wall and the first partition plate, so that a speed at which liquid in the second cavity flows into the first cavity through the channel can be increased. This improves impact effect of the liquid flowing into the first cavity, strengthens boiling heat transfer, and improves heat dissipation effect.

In a possible design, an end that is of the first partition plate and that is close to the air outlet is connected to a side wall opposite to the first side wall by using a fourth partition plate. One face of the fourth partition plate faces the second side wall, and the other face of the fourth partition plate faces the third side wall. The fourth partition plate may block an area between the first partition plate and the side wall opposite to the first side wall, so that a speed at which liquid in the second cavity flows into the first cavity through the channel can be increased. This improves impact effect of the liquid flowing into the first cavity, strengthens boiling heat transfer, and improves heat dissipation effect.

In a possible design, an end that is of the first partition plate and that is away from the air outlet is connected to the first side wall of the housing by using a third partition plate. One face of the third partition plate faces the second side wall, and the other face of the third partition plate faces the third side wall. An end that is of the first partition plate and that is close to the air outlet is connected to a side wall opposite to the first side wall by using a fourth partition plate. One face of the fourth partition plate faces the second side wall, and the other face of the fourth partition plate faces the third side wall. The third partition plate may block an area between the first side wall and the first partition plate, and the fourth partition plate may block an area between the first partition plate and the side wall opposite to the first side wall, so that a speed at which liquid in the second cavity flows into the first cavity through the channel can be increased. This improves impact effect of the liquid flowing into the first cavity, strengthens boiling heat transfer, and improves heat dissipation effect.

In a possible design, the at least one channel on the first partition plate is a via hole. Optionally, each channel on the first partition plate may be a via hole. Optionally, the first partition plate may include the protrusion part, and at least one via hole may be provided on the protrusion part.

In a possible design, the at least one channel on the first partition plate is a flow guiding tube, and the flow guiding tube is disposed on the side that is of the first partition plate and that faces the first side wall. Optionally, each channel on the first partition plate is a flow guiding tube. In some examples, one part of the channels on the first partition plate are via holes, and the other part of the channels on the first partition plate are flow guiding tubes. Optionally, the first partition plate may include the protrusion part, and at least one flow guiding tube may be provided on the protrusion part.

In a possible design, a heat conduction member extending toward the inside of the first cavity is provided on an inner surface of the heat conduction substrate. The heat conduction member may promote or strengthen the refrigerant in the first cavity to change from the liquid state to the gas state. This improves the heat dissipation effect for the heat source. A projection of the heat conduction member on the first partition plate and each channel avoid each other.

In a possible design, a projection of a free end of the heat conduction member on the second side wall partially overlaps a projection of the flow guiding tube on the second side wall, so that the refrigerant in the liquid state flowing out of the flow guiding tube can reach the inner surface of the heat conduction substrate more easily.

In a possible design, the second side wall and the third side wall are opposite to each other in a gravity direction, and the first side wall is located between the second side wall and the third side wall. In addition, the second side wall is located above the third side wall in the gravity direction, that is, the third side wall is located below the second side wall. The first partition plate is connected to or abuts against the third side wall (1104), and the liquid inlet is provided at an area that is of the third side wall and that is located between the first side wall and the first partition plate. Such a design can increase a speed at which liquid in the second cavity flows into the first cavity through the channel. This improves impact effect of the liquid flowing into the first cavity, strengthens boiling heat transfer, and improves heat dissipation effect.

According to a second aspect, this application provides a power device. The power device may include at least one power module and the heat dissipation apparatus provided in any one of the first aspect and the possible designs of the first aspect. An outer surface of a first side wall of a housing of the heat dissipation apparatus may be used for fastening the power module. Alternatively, a heat conduction substrate in an opening of a first side wall may carry the power module.

In a possible design, the power device may further include a condenser, configured to liquefy a refrigerant in a gas state into the refrigerant in a liquid state. The condenser may be separately coupled to an air outlet and a liquid inlet of the heat dissipation apparatus. Optionally, a second side wall on which the air outlet is located and a third side wall on which the liquid inlet is located are opposite to each other in a gravity direction, and the second side wall is located above the third side wall. In the power device, the condenser is located at the top of the heat dissipation apparatus in the gravity direction. The condenser is coupled to the air outlet and the liquid inlet of the heat dissipation apparatus, and is configured to convert the refrigerant in the gas state into the refrigerant in the liquid state. In such a design, the power device may not need to use a driving device, for example, a pump or a motor, to drive liquid to flow inside the heat dissipation apparatus or a gas to flow inside the heat dissipation apparatus.

According to a third aspect, this application provides a photovoltaic system, including a panel and the foregoing power device. The panel is configured to convert solar energy into electric energy, and the power device is configured to convert a current and/or a voltage from the panel.

### BRIEF DESCRIPTION OF DRAWINGS

FIG. 1 is a diagram of a structure of a heat dissipation apparatus;
FIG. 2 shows an application scenario of a heat dissipation apparatus;
FIG. 3 is a diagram of a partial structure of a heat dissipation apparatus;
FIG. 4A is a side sectional view of a heat dissipation apparatus according to an embodiment of this application;
FIG. 4B is a diagram of the heat dissipation apparatus shown in FIG. 4A in a front view;
FIG. 5A is a side sectional view of a heat dissipation apparatus according to an embodiment of this application;
FIG. 5B is a diagram of the heat dissipation apparatus shown in FIG. 5A in a front view;
FIG. 6A is a diagram of a first partition plate;
FIG. 6B is a diagram of another first partition plate;
FIG. 7A is a diagram of still another first partition plate;
FIG. 7B is a diagram of still another first partition plate;
FIG. 7C is a diagram of still another first partition plate;
FIG. 7D is a diagram of still another first partition plate;
FIG. 7E is a diagram of still another first partition plate;
FIG. 8A is a diagram of still another first partition plate;
FIG. 8B is a diagram of still another first partition plate;
FIG. 8C is a diagram of still another first partition plate;
FIG. 9A is a diagram of still another first partition plate;
FIG. 9B is a diagram of still another first partition plate;
FIG. 9C is a diagram of still another first partition plate;
FIG. 9D is a diagram of still another first partition plate;
FIG. 9E is a diagram of still another first partition plate;
FIG. 10A is a side sectional view of a heat dissipation apparatus according to an embodiment of this application;
FIG. 10B is a diagram of the heat dissipation apparatus shown in FIG. 10A in a front view;
FIG. 10C is a diagram of a heat dissipation apparatus in a front view according to an embodiment of this application;
FIG. 10D is a diagram of another heat dissipation apparatus in a front view according to an embodiment of this application;
FIG. 11A is a side sectional view of a heat dissipation apparatus according to an embodiment of this application;
FIG. 11B is a diagram of the heat dissipation apparatus shown in FIG. 11A in a front view;
FIG. 11C is a diagram of still another heat dissipation apparatus in a front view according to an embodiment of this application;
FIG. 11D is a diagram of still another heat dissipation apparatus in a front view according to an embodiment of this application;
FIG. 12 is a side sectional view of still another heat dissipation apparatus according to an embodiment of this application;
FIG. 13 is a side sectional view of still another heat dissipation apparatus according to an embodiment of this application;
FIG. 14 is a side sectional view of still another heat dissipation apparatus according to an embodiment of this application; and
FIG. 15 is a side sectional view of still another heat dissipation apparatus according to an embodiment of this application.

Reference numerals:
100: heat dissipation apparatus;
110: housing; 1101: first side wall; 1103: second side wall; 1104: third side wall; 1102: fourth side wall; 1105: fifth side wall; 1106: sixth side wall; 1131: heat dissipation area; 1131a: opening; 1132: air outlet; 1133: liquid inlet; 1101b: heat conduction substrate; 21: heat conduction member;
111: first partition plate; 1111: channel; 1111a: via hole; 1111b: flow guiding tube; 1111c: protrusion part;
112: first cavity; 113: second cavity; 114a: horizontal heat source partition plate; 114b: vertical heat source partition plate; 116: third partition plate; 117: fourth partition plate.

### DESCRIPTION OF EMBODIMENTS

To make the objectives, technical solutions, and advantages of this application clearer, the following further describes this application in detail with reference to the accompanying drawings. However, example implementations can be implemented in a plurality of forms, and shall not be construed as being limited to implementations described herein. Identical reference numerals in the accompanying drawings indicate identical or similar structures. Therefore, repeated descriptions thereof are omitted. Expressions of positions and directions in embodiments of this application are described by using the accompanying drawings as examples. However, changes may be made as required, and all the changes fall within the protection scope of this application. The accompanying drawings in embodiments of this application are merely used to illustrate relative position relationships and do not indicate an actual scale.

It should be noted that specific details are set forth in the following descriptions for ease of understanding of this application. However, this application can be implemented in a plurality of manners different from those described herein, and a person skilled in the art can perform similar promotion without departing from the connotation of this application. Therefore, this application is not limited to the following disclosed specific implementations.

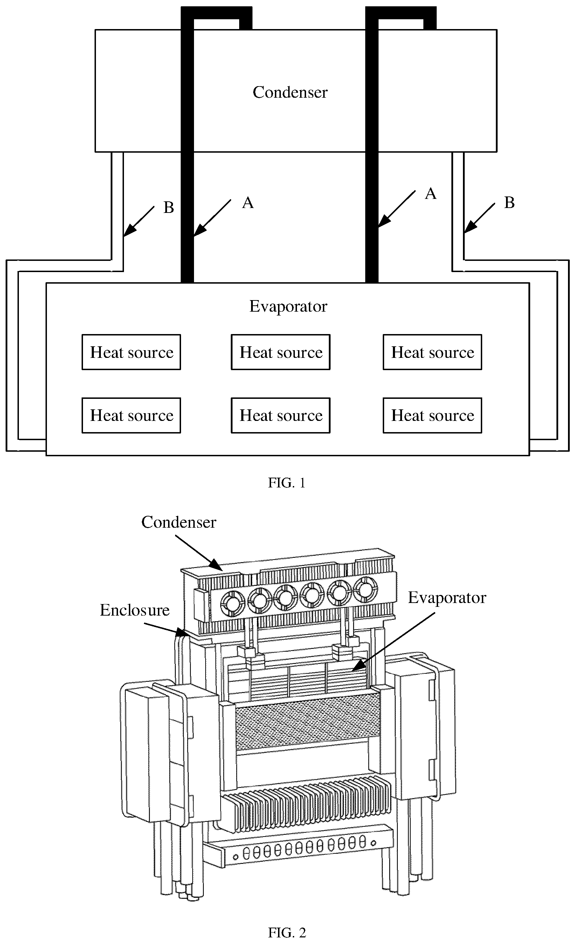

A loop gravity thermosyphon (loop thermosyphon, LTS) heat dissipation apparatus is an important application form in two-phase liquid cooling. Refer to FIG. 1. The LTS heat dissipation apparatus usually includes an evaporator, a condenser, a steam pipeline (as shown by an arrow A in FIG. 1), and a liquid return pipeline (as shown by an arrow B in FIG. 1). The heat dissipation apparatus is filled with refrigerants, and a heat source is mounted on the evaporator. After being heated, a working fluid in a liquid state boils into steam, enters the condenser along the steam pipeline, is cooled and liquefied in the condenser, and flows back to the evaporator along the liquid return pipeline under driving of gravity, to complete circulation.

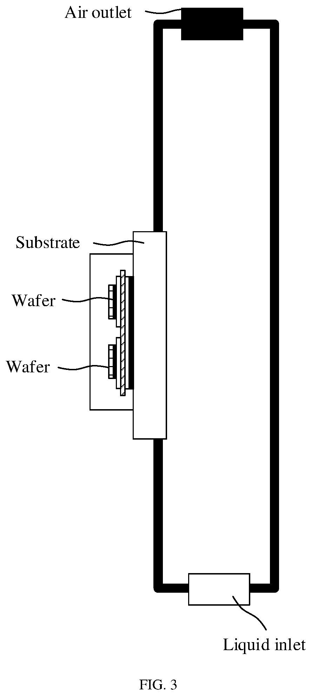

FIG. 2 shows an application scenario of a heat dissipation apparatus. The LTS heat dissipation apparatus may be used in a heat dissipation scenario of an inverter. As shown in FIG. 2, the heat dissipation apparatus may be securely mounted on an enclosure of the inverter, and the evaporator is disposed inside the enclosure of the inverter. Optionally, the condenser may be disposed at the top of the enclosure of the inverter. At least one liquid return pipeline and at least one steam pipeline are disposed between the condenser and the evaporator. The heat dissipation apparatus is configured to dissipate heat for a power module in the inverter. The power component may be securely mounted on a surface of one side wall of the evaporator, and the heat dissipation apparatus may dissipate heat for a substrate (for example, a heat conduction substrate) on which the power module is located. FIG. 3 is a diagram of a partial structure of a heat dissipation apparatus. A heat dissipation area is provided on one side wall of the evaporator of the heat dissipation apparatus, and the substrate of the power module may be fastened to the heat dissipation area. The heat dissipation area may be configured to dissipate heat for the substrate. Optionally, an opening is provided on the heat dissipation area. The opening may accommodate the substrate of the power module. At least one wafer is integrated on a first side of the substrate. A second side of the substrate may be in contact with the refrigerant inside the evaporator. Usually, the wafer on the substrate is a main heat source of the power module.

When the LTS heat dissipation apparatus is under a high heat load, it is difficult to supplement liquid in the evaporator. This limits heat exchange effect and easily causes overheating of a wall surface of the evaporator under the high heat load. In view of the foregoing problem, the heat dissipation apparatus is improved in embodiments of this application, so that heat exchange effect of the heat dissipation apparatus can be improved, and heat dissipation effect can be good under the high heat load. The following specifically describes the power device provided in embodiments of this application with reference to the accompanying drawings.

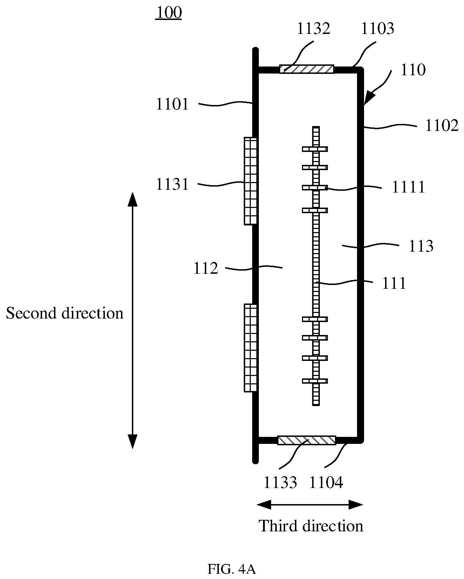

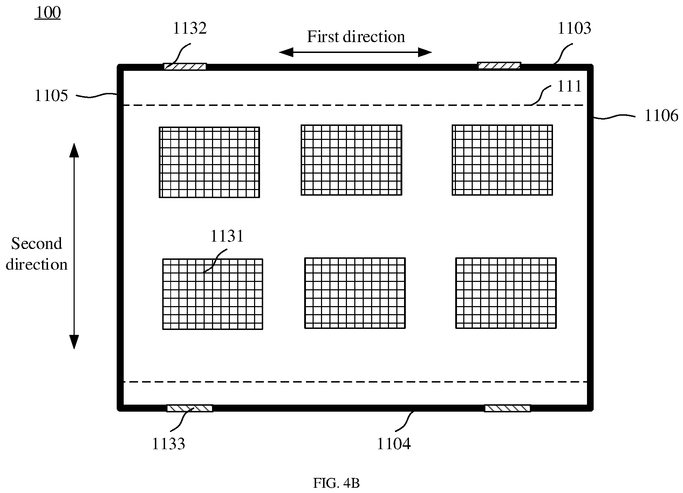

Refer to both FIG. 4A and FIG. 4B. FIG. 4A is a side sectional view of a heat dissipation apparatus 100 according to an embodiment of this application. FIG. 4B is a diagram of the heat dissipation apparatus in a front view. In this embodiment, the heat dissipation apparatus 100 may include a housing 110. For example, the housing 110 may be approximately a cuboid structure, and includes a first side wall 1101, a second side wall 1103, a third side wall 1104, a fourth side wall 1102, a fifth side wall 1105, and a sixth side wall 1106. It should be noted that they represent six different side walls of the housing 110.

Optionally, the first side wall 1101 and the fourth side wall 1102 may be opposite to each other in a third direction, the second side wall 1103 and the third side wall 1104 may be opposite to each other in a second direction, and the fifth side wall 1105 and the sixth side wall 1106 may be opposite to each other in a first direction. Optionally, a minimum included angle between the third direction and the second direction may be greater than 0° and less than or equal to 90°, a minimum included angle between the second direction and the first direction may be greater than 0° and less than or equal to 90°, and a minimum included angle between the third direction and the first direction may be greater than 0° and less than or equal to 90°.

It should be learned that the heat dissipation apparatus 100 shown in FIG. 4A and FIG. 4B is merely an embodiment, and there are other embodiments in this application. Fundamentally, the first side wall 1101, the fourth side wall 1102, the second side wall 1103, the third side wall 1104, the fifth side wall 1105, and the sixth side wall 1106 merely indicate that they respectively represent the six different side walls of the housing 110. In some embodiments, the first side wall 1101 may be opposite to the third side wall 1104. In some embodiments, the first side wall 1101 may be opposite to the second side wall 1103. There are other embodiments in this application, which are not enumerated herein.

Optionally, every two of the first direction, the second direction, and the third direction are perpendicular to each other.

Optionally, in a scenario in which the heat dissipation apparatus 100 is configured to dissipate heat for a power component in an inverter, the first direction is a width direction of the inverter, the second direction is a height direction of the inverter, and the third direction is a thickness direction of the inverter.

A first partition plate 111 may be disposed inside the housing 110. One face of the first partition plate 111 faces the first side wall 1101, and the other face of the first partition plate 111 is away from the first side wall 1101. The first partition plate 111 may partition the housing 110 into two cavities: a first cavity 112 and a second cavity 113. One or more channels 1111 are provided on the first partition plate 111. Each channel 1111 is configured to communicate the first cavity 112 with the second cavity 113. For ease of description, a cavity between the first partition plate 111 and the first side wall 1101 is denoted as the first cavity 112, and a cavity between the first partition plate 111 and a side wall opposite to the first side wall 1101 is denoted as the second cavity 113. For example, in FIG. 4A, a cavity between the fourth side wall 1102 and the first partition plate 111 is the second cavity 113.

An air outlet 1132 is provided on a side wall of the housing 110 other than the first side wall 1101. A liquid inlet 1133 may be provided on one of side walls of the housing 110 other than the first side wall 1101 and the side wall provided with the air outlet 1132. In some embodiments, the side wall provided with the air outlet 1132 and the side wall provided with the liquid inlet 1133 may not be opposite to each other. In some other embodiments, the side wall provided with the air outlet 1132 and the side wall provided with the liquid inlet 1133 may be opposite to each other. Optionally, the side wall provided with the air outlet 1132 and the side wall provided with the liquid inlet 1133 may be opposite to each other in a gravity direction. Optionally, the side wall provided with the air outlet 1132 and the side wall provided with the liquid inlet 1133 may be opposite to each other in a direction perpendicular to a gravity direction.

For example, in FIG. 4A, the air outlet 1132 is provided on the second side wall 1103. The liquid inlet 1133 may be provided on one of side walls of the housing 110 other than the first side wall 1101 and the second side wall 1103. Optionally, the liquid inlet 1133 is provided on the third side wall 1104.

The heat dissipation apparatus 100 may dissipate heat for at least one heat source. In a possible design, a heat source may be fastened to an outer surface of the first side wall 1101 of the housing 110. In FIG. 4A and FIG. 4B, an area 1131 that is of the first side wall 1101 and to which the heat source is fastened may be denoted as a heat dissipation area 1131.

In a possible scenario, the heat dissipation area 1131 is formed on a first surface of the first side wall 1101. The first surface is a surface that is of the first side wall 1101 and that is away from the second side wall 1103. The heat source may be securely mounted on the heat dissipation area 1131, and the heat source may be in contact with or attached to the heat dissipation area 1131. For example, the heat source is a power module. A heat conduction substrate of the power module may be securely mounted on the heat dissipation area 1131, so that the heat conduction substrate is in contact with or attached to the heat dissipation area 1131.

Optionally, an end that is of each channel 1111 on the first partition plate 111 and that is close to the first side wall 1101 faces the area that is of the first side wall 1101 and to which the heat source is fastened, namely, the heat dissipation area 1131. In a scenario in which the heat dissipation apparatus 100 may dissipate heat for a plurality of heat sources, a plurality of heat dissipation areas 1131 may be formed on the outer surface of the first side wall 1101, and each heat dissipation area 1131 may be used for fastening the heat source. Each heat dissipation area 1131 directly faces at least one first channel 1111. In other words, a projection of one heat dissipation area 1131 on the first partition plate 111 includes at least one first channel 1111.

A refrigerant may be input to the inside of the first housing 110 through the liquid inlet 1133. Usually, the refrigerant in the housing 110 may immerse all channels 1111 on the first partition plate 111. Each channel 1111 may communicate the second cavity 113 with the first cavity 112. A refrigerant in the second cavity 113 may enter the first cavity 112 through the channel 1111. The first cavity 112 is close to the heat source. The refrigerant usually undergoes phase transition in the first cavity 112. In the first cavity 112, after absorbing a large amount of heat, the refrigerant changes from a liquid state to a gas state. Therefore, the first cavity 112 may also be referred to as a boiling cavity. The second cavity 113 may also be referred to as a liquid collection cavity.

In such a design, at least one channel 1111 is provided on the first partition plate 111. Each channel 1111 may communicate the first cavity 112 with the second cavity 113. An end that is of each channel 1111 and that is close to the first side wall 1101 faces the area that is of the first side wall 1101 and to which the heat source is fastened. The refrigerant undergoes phase transition in the first cavity 112. A density of the refrigerant in the first cavity 112 is less than a density of the refrigerant in the second cavity 113, so that pressure is formed. Therefore, the refrigerant in the liquid state in the second cavity 113 flows into the first cavity 112 through the channel 1111 under an action of the pressure. A working fluid (for example, a coolant or a refrigerant) in a liquid state in the first cavity 112 undergoes phase transition and is gasified under impact of heat of the heat source, to cool the heat source. In addition, the channel 1111 faces the area that is of the first side wall 1101 and to which the heat source is fastened, so that a coolant in the second cavity 113 can directly flow to the heat source through the channel 1111. This improves heat dissipation efficiency.

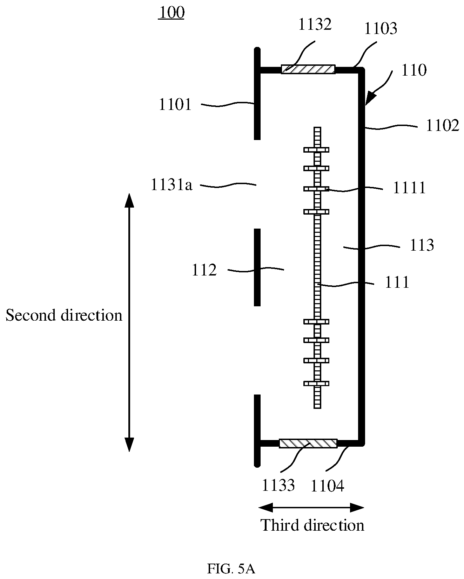

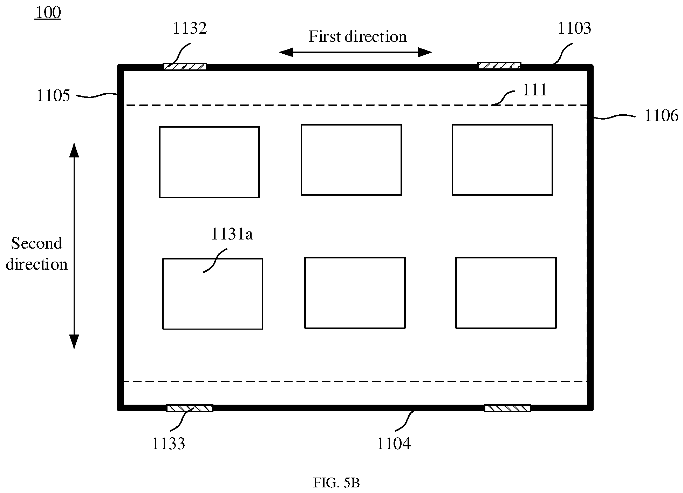

In a possible design, as shown in both FIG. 5A and FIG. 5B, an opening 1131a is provided on the first side wall 1101 of the housing 110. A heat source is fastened to an outer surface of a heat conduction substrate embedded in the opening 1131a. For example, the heat conduction substrate embedded in the opening 1131a may be configured to carry the heat source. An end that is of each channel 1111 on the first partition plate 111 and that is close to the first side wall 1101 faces the heat conduction substrate, that is, faces the opening 1131a.

An inner peripheral wall of the opening 1131a may be in a sealing fit with an outer peripheral wall of the heat conduction substrate embedded in the opening 1131a. In some examples, the inner peripheral wall of the opening 1131a is in direct contact with the outer peripheral wall of the heat conduction substrate embedded in the opening 1131a. Optionally, the opening 1131a is in an interference fit with the heat conduction substrate embedded in the opening 1131a. Alternatively, the inner peripheral wall of the opening 1131a is in contact, through a sealing material, with the outer peripheral wall of the heat conduction substrate embedded in the opening 1131a, to implement a sealing fit. For example, a sealing ring is disposed between the inner peripheral wall of the opening 1131a and the outer peripheral wall of the heat conduction substrate embedded in the opening 1131a. It may be understood that, the opening 1131a is in a sealing fit with the heat conduction substrate embedded in the opening 1131a, to prevent the inside of the housing 110 from communicating with the outside of the housing 110 through the opening 1131a. This reduces risks of air leakage and liquid leakage at the opening 1131a. For similarities between FIG. 5A and FIG. 4A and similarities between FIG. 5B and FIG. 4B, refer to related descriptions of FIG. 4A and FIG. 4B. Details are not described herein.

In such a design, the at least one channel 1111 is provided on the first partition plate 111. Each channel 1111 may communicate the first cavity 112 with the second cavity 113. The end that is of each channel 1111 and that is close to the first side wall 1101 faces the heat conduction substrate embedded in the opening 1131a of the first side wall 1101. A refrigerant undergoes phase transition in the first cavity 112. A density of the refrigerant in the first cavity 112 is less than a density of a refrigerant in the second cavity 113, so that pressure is formed. Therefore, the refrigerant in a liquid state in the second cavity 113 flows into the first cavity 112 through the channel 1111 under an action of the pressure. A working fluid (for example, a coolant) in a liquid state in the first cavity 112 undergoes phase transition and is gasified under impact of heat of the heat source, to cool the heat source. In addition, the channel 1111 faces the heat conduction substrate embedded in the opening 1131a of the first side wall 1101, so that a coolant in the second cavity 113 can directly flow to the heat conduction substrate through the channel 1111. This improves heat dissipation efficiency for the heat source carried on the heat conduction substrate.

Based on the heat dissipation apparatus 100 provided in any one of the foregoing designs, in a possible design, the second side wall 1103 and the third side wall 1104 of the housing 110 are opposite to each other in the gravity direction, and the first side wall 1101 is located between the second side wall 1103 and the third side wall 1104. The second side wall 1103 is located above the third side wall 1104. Refer to FIG. 4A. The air outlet 1132 and the liquid inlet 1133 are respectively provided on side walls that are opposite to each other in the gravity direction, and the air outlet 1132 is located above the liquid inlet 1133. In some application scenarios, in the gravity direction, a condenser may be disposed at the top of the heat dissipation apparatus 100, is separately coupled to the air outlet 1132 and the liquid inlet 1133 of the heat dissipation apparatus, and is configured to convert a refrigerant in a gas state into the refrigerant in a liquid state. In such a design, there may be no need to use a driving device, for example, a pump or a motor, to drive liquid to flow inside the housing 110 or a gas to flow inside the housing 110.

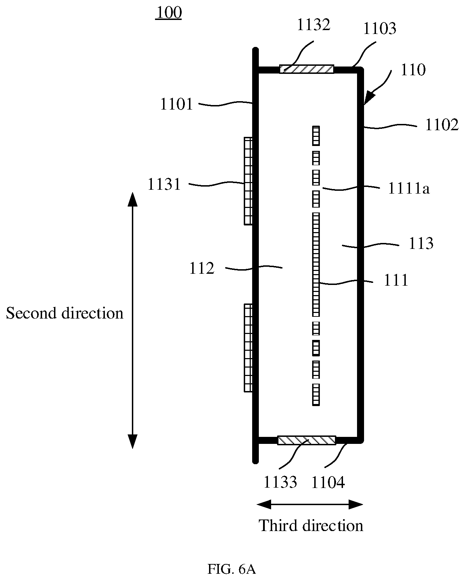

In the heat dissipation apparatus 100 provided in this embodiment of this application, the channel 1111 provided on the first partition plate 111 may have a plurality of forms. In a specific implementation, as shown in FIG. 6A, at least one of channels 1111 on the first partition plate 111 may be a via hole 1111a. In embodiments of this application, the via hole 1111a on the first partition plate 111 may also be referred to as a jet orifice. For similarities between FIG. 6A and FIG. 4A, details are not described herein. The density of the refrigerant in the first cavity 112 is less than the density of the refrigerant in the second cavity 113, so that the pressure is formed. Therefore, the refrigerant in the liquid state in the second cavity 113 flows into the first cavity 112 through the via hole 1111a under the action of the pressure. Optionally, each of the channels 1111 on the first partition plate 111 is a via hole 1111a.

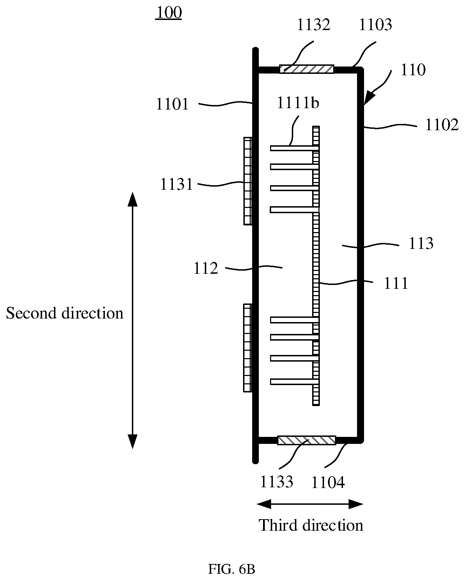

As shown in FIG. 6B, at least one of channels 1111 on the first partition plate 111 may be a flow guiding tube 1111b. The flow guiding tube in this application may also be referred to as a jet tube. For similarities between FIG. 6B and FIG. 4A, details are not described herein. The density of the refrigerant in the first cavity 112 is less than the density of the refrigerant in the second cavity 113, so that the pressure is formed. Therefore, the refrigerant in the liquid state in the second cavity 113 flows into the first cavity 112 through the flow guiding tube 1111b under the action of the pressure. The flow guiding tube 1111b may increase a speed at which the refrigerant in the second cavity 113 flowing into the first cavity 112, to improve efficiency in supplementing the first cavity 112 with liquid and therefore improve heat dissipation effect. Optionally, each of the channels 1111 on the first partition plate 111 is a flow guiding tube 1111b.

In a possible scenario, one part of the channels 1111 on the first partition plate 111 are via holes 1111a, and the other part of the channels 1111 on the first partition plate 111 are flow guiding tubes 1111b. This is not excessively limited in embodiments of this application.

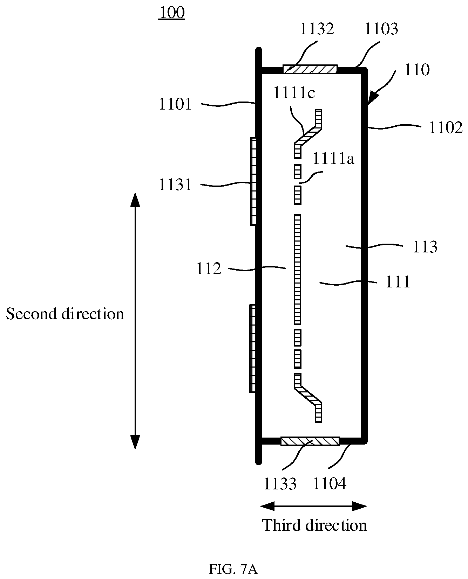

In a specific implementation, a side that is of the first partition plate 111 and that is close to the first side wall 1101 may have one protrusion part. As shown in FIG. 7A, one protrusion part 1111c is provided on the side that is of the first partition plate 111 and that is close to the first side wall 1101. One or more channels 1111 are provided on the protrusion part 1111c. An end that is of each channel 1111 and that is close to the first side wall 1101 faces the area that is of the first side wall 1101 and to which the heat source is fastened or faces the heat conduction substrate embedded in the opening of the first side wall 1101.

In a possible case, still as shown in FIG. 7A, all channels 1111 on the first partition plate 111 are provided on the protrusion part 1111c. In such a design, a distance from liquid in the channel 1111 to the heat source can be shortened by using the protrusion part 1111c. In some examples, the first partition plate 111 is provided with one channel 1111, and the channel 1111 is provided on the protrusion part 1111c. The channel 1111 may be a via hole or a flow guiding tube. In some examples, the first partition plate 111 is provided with a plurality of channels 1111, and all channels 1111 on the first partition plate 111 are provided on the protrusion part 1111c. Optionally, one part of all channels 1111 on the protrusion part 1111c may be via holes, and the other part of the channels 1111 on the protrusion part 1111c may be flow guiding tubes. Alternatively, each of all channels 1111 on the protrusion part 1111c may be a flow guiding tube. Alternatively, each of all channels 1111 on the protrusion part 1111c may be a via hole. For example, in FIG. 7A, each of all channels 1111 on the first partition plate 111 is a via hole 1111a. Each via hole 1111a on the first partition plate 111 is provided on the protrusion part 1111c.

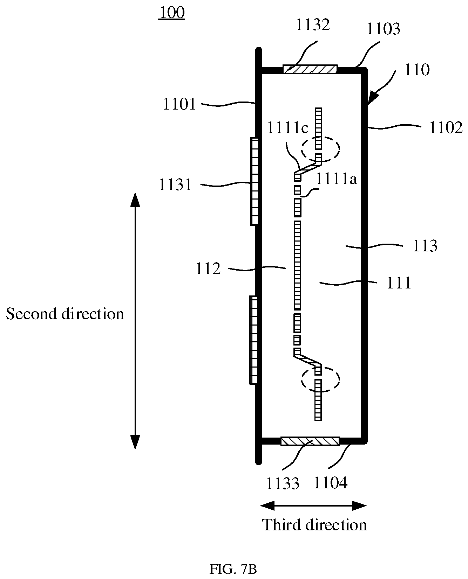

In another possible case, a plurality of channels 1111 are provided on the first partition plate 111. One part of the channels 1111 on the first partition plate 111 are provided on the protrusion part 1111c, and the other part of the channels 1111 avoid the protrusion part 1111c. In such a design, a distance from liquid in one part of the channels 1111 to the heat source or the heat conduction substrate can be shortened by using the protrusion part 1111c. For example, the channels 1111 provided on the first partition plate 111 are all via holes 1111a. As shown in FIG. 7B, the via hole 1111a in a dashed circle is a via hole that avoids the protrusion part 1111c. Optionally, in all channels 1111 on the first partition plate 111, there may be one or more channels 1111 that avoid the protrusion part 1111c.

In some examples, there is one channel 1111 provided on the protrusion part 1111c. In this case, the channel 1111 on the protrusion part 1111c may be a via hole or a flow guiding tube. In some examples, there is more than one channel 1111 provided on the protrusion part 1111c. Optionally, one part of all channels 1111 on the protrusion part 1111c may be via holes, and the other part of the channels 1111 on the protrusion part 1111c may be flow guiding tubes. Alternatively, each of all channels 1111 on the protrusion part 1111c may be a flow guiding tube. Alternatively, each of all channels 1111 on the protrusion part 1111c may be a via hole. For example, in FIG. 7B, each of all channels 1111 on the first partition plate 111 is a via hole 1111a. Each via hole 1111a on the first partition plate 111 is provided on the protrusion part 1111c.

In some examples, there is one channel 1111 that is on the first partition plate 111 and that avoids the protrusion part 1111c. In this case, the channel 1111 that is on the first partition plate 111 and that avoids the protrusion part 1111c may be a via hole or a flow guiding tube. In some examples, there is more than one channel 1111 that is on the first partition plate 111 and that avoids the protrusion part 1111c. Optionally, one part of the channels 1111 that are on the first partition plate 111 and that avoid the protrusion part 1111c may be via holes, and the other part of the channels 1111 that are on the first partition plate 111 and that avoid the protrusion part 1111c may be flow guiding tubes. Alternatively, each of the channels 1111 that is on the first partition plate 111 and that avoids the protrusion part 1111c may be a flow guiding tube. Alternatively, each of the channels 1111 that is on the first partition plate 111 and that avoids the protrusion part 1111c may be a via hole. For example, in FIG. 7B, each of the channels 1111 that is on the first partition plate 111 and that avoids the protrusion part 1111c is a via hole 1111a.

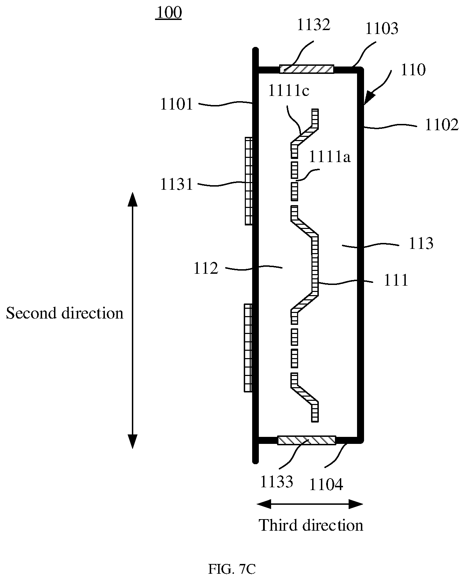

In a specific implementation, the side that is of the first partition plate 111 and that is close to the first side wall 1101 may have a plurality of protrusion parts. In FIG. 7C, a plurality of protrusion parts 1111c are provided on the side that is of the first partition plate 111 and that is close to the first side wall 1101. Any one of the plurality of protrusion parts 1111c may be a first protrusion part. One or more channels 1111 may be provided on the first protrusion part 1111c. An end that is of the channel 1111 provided on the first protrusion part and that may be close to the first side wall 1101 faces the area that is of the first side wall 1101 and to which the heat source is fastened or faces the heat conduction substrate embedded in the opening of the first side wall 1101. Cases of the channel on the first protrusion part may include but are not limited to a case shown in any one of the following examples. In some examples, one channel 1111 is provided on the first protrusion part 1111c. In this case, the channel 1111 on the first protrusion part 1111c may be a via hole or a flow guiding tube. In some examples, there is more than one channel 1111 on the first protrusion part 1111c. Optionally, one part of all channels 1111 on the first protrusion part 1111c may be via holes, and the other part of the channels 1111 on the first protrusion part 1111c may be flow guiding tubes. Alternatively, each of all channels 1111 on the first protrusion part 1111c may be a flow guiding tube. Alternatively, each of all channels 1111 on the first protrusion part 1111c may be a via hole.

In a possible case, still as shown in FIG. 7C, all channels 1111 on the first partition plate 111 are provided on the protrusion part 1111c on the first partition plate 111. In the plurality of protrusion parts 1111c on the first partition plate 111, quantities of channels 1111 on the protrusion parts 1111c may be the same or different. For example, each of all channels 1111 on the first partition plate 111 is a via hole 1111a.

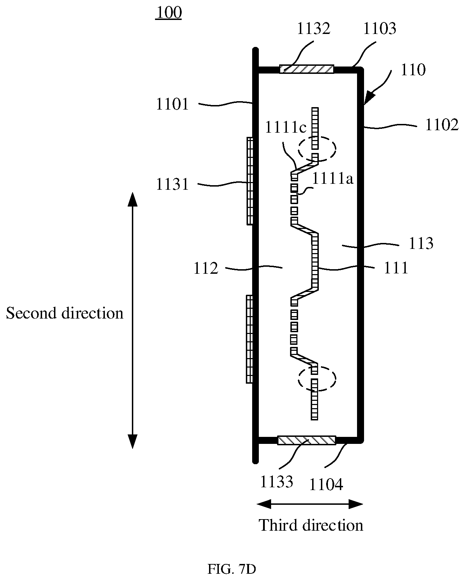

In another possible case, as shown in FIG. 7D, one part of all channels 1111 on the first partition plate 111 are provided on the protrusion part 1111c on the first partition plate 111, and the other part of the channels 1111 on the first partition plate 111 avoid each protrusion part 1111c on the first partition plate 111.

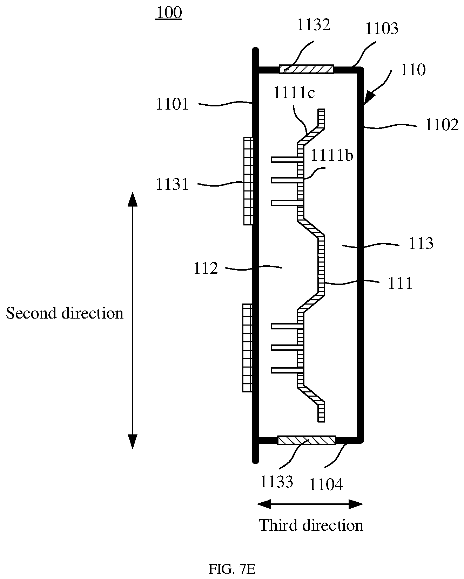

In a specific implementation, as shown in FIG. 7E, the side that is of the first partition plate 111 and that is close to the first side wall 1101 has a plurality of protrusion parts 1111c. All channels 1111 on the first partition plate 111 are provided on the plurality of protrusion parts 1111c. Optionally, quantities of channels on the protrusion parts 1111c may be the same or different. The channels 1111 on the protrusion parts 1111c may be all flow guiding tubes 1111b. In such a design, a distance between the refrigerant and the heat source can be shortened by using the flow guiding tube 1111b on the protrusion part 1111c.

Based on the heat dissipation apparatus 100 provided in any one of the foregoing embodiments, the heat source is fastened to the outer surface of the first side wall 1101 in the heat dissipation apparatus 100, or the heat conduction substrate embedded in the opening of the first side wall 1101 carries the heat source. In some application scenarios, the heat source may include at least one wafer. In a scenario in which the heat dissipation apparatus dissipates heat for the inverter, the wafer in the power module of the inverter is a main heat generation component.

In a specific implementation, the at least one channel 1111 on the first partition plate 111 may directly face the wafer. Alternatively, the at least one channel 1111 on the protrusion part 1111c of the first partition plate 111 may directly face the wafer. Optionally, the at least one channel 1111 on the first partition plate 111 is the via hole 1111a, and the at least one via hole 1111a directly faces the wafer.

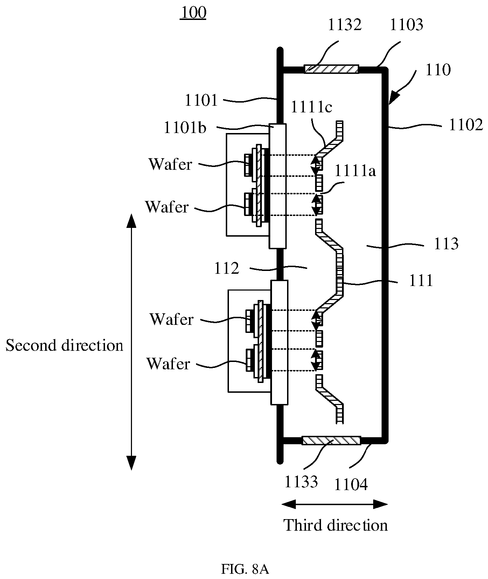

For example, as shown in FIG. 8A, the wafer in the heat source is carried by the heat conduction substrate 1101b embedded in the opening of the first side wall 1101. The channels 1111 on the first partition plate 111 are all via holes 1111a. An arrow in FIG. 8A shows a projection of the wafer on the first partition plate 111. The projection of the wafer on the first partition plate 111 partially or completely overlaps the at least one via hole 1111a. In other words, the at least one via hole 1111a on the first partition plate 111 directly faces the wafer in the heat source.

In a specific implementation, to enable a refrigerant in the gas state at the area that is of the outer surface of the first side wall 1101 and to which the heat source is fastened to be released from the area easily, or to enable a refrigerant in the gas state at the heat conduction substrate embedded in the opening of the first side wall 1101 to be released from the heat conduction substrate easily, each channel 1111 on the first partition plate 111 and each wafer in the heat source may avoid each other. For example, a projection of each wafer in the heat source on the first partition plate 111 and each channel 1111 on the first partition plate 111 avoid each other. Optionally, the channels 1111 on the first partition plate 111 may be all via holes 1111a. Alternatively, the channels 1111 on the first partition plate 111 may be all flow guiding tubes 1111b. Alternatively, the first partition plate 111 has a plurality of channels 1111. At least one channel is the via hole 1111a, and at least one channel is the flow guiding tube 1111b.

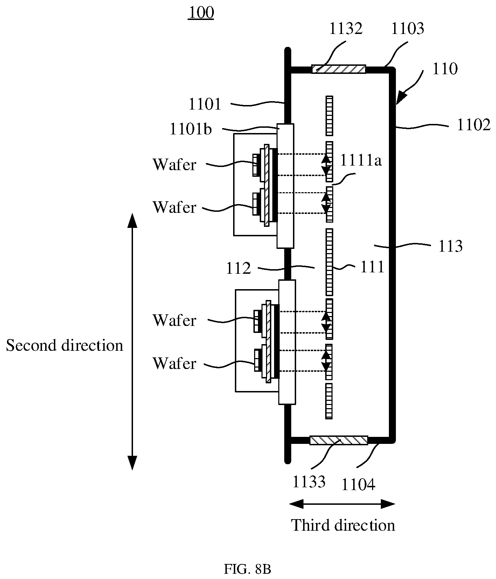

In some examples, as shown in FIG. 8B, the channels 1111 on the first partition plate 111 are all via holes 1111a. An arrow in FIG. 8B shows a projection of the wafer on the first partition plate 111. Projections of the wafers on the first partition plate 111 and the via holes 1111a avoid each other. In other words, the projections of the wafers on the first partition plate 111 do not overlap the via holes 1111a.

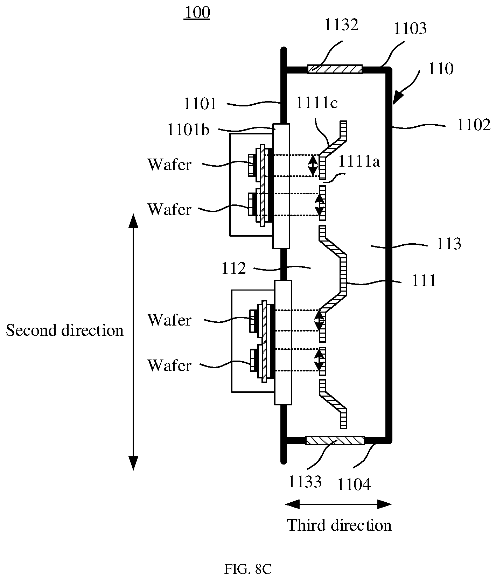

In some examples, as shown in FIG. 8C, the side that is of the first partition plate 111 and that is close to the first side wall 1101 has one or more protrusion parts 1111c. The channels 1111 on the protrusion parts 1111c are all via holes 1111a. An arrow in FIG. 8C shows a projection of the wafer on the first partition plate 111. Projections of the wafers on the first partition plate 111 and the via holes 1111a on the protrusion parts 1111c avoid each other. In other words, the projections of the wafers on the first partition plate 111 do not overlap the via holes 1111a.

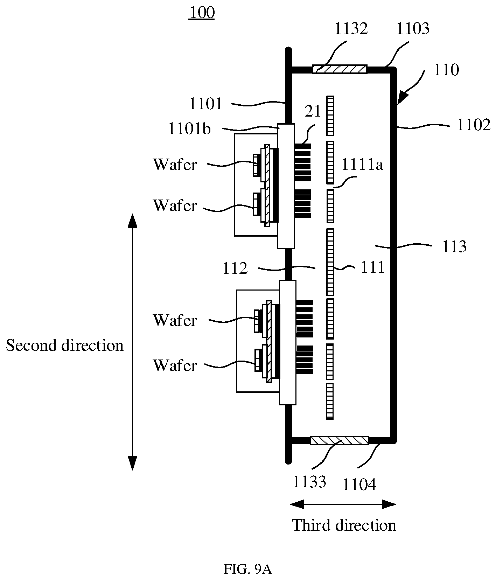

In a possible case, one or more openings are provided on the first side wall 1101 of the heat dissipation apparatus 100, and the heat conduction substrate embedded in the opening of the first side wall 1101 carries the heat source. In a possible application scenario, as shown in FIG. 9A, a heat conduction member 21 extending toward the inside of the first cavity 112 or extending toward the first partition plate 111 is provided on an inner surface of the heat conduction substrate 1101b embedded in the opening. The inner surface of the heat conduction substrate 1101b is a surface that is of the heat conduction substrate 1101b and that is away from the heat source and close to the first cavity 112. The heat conduction member 21 on the inner surface of the heat conduction substrate 1101b may be usually referred to as a surface structure on the inner surface. The heat conduction member 21 on the inner surface of the heat conduction substrate 1101b may be configured to promote or strengthen the refrigerant in the first cavity 112 to change from the liquid state to the gas state. This improves the heat dissipation effect for the heat source. The heat conduction member 21 may be a three-dimensional structure or a layered structure disposed on the inner surface of the heat conduction substrate 1101b. This is not excessively limited in this application. Optionally, the heat conduction member 21 may be but is not limited to in a form of a micro pin fin array, sintered metal powder, and the like.

In a specific implementation, a projection, of the heat conduction member 21 on the inner surface of the heat conduction substrate 1101b embedded in the opening, on the first partition plate 111 and each channel 1111 on the first partition plate 111 avoid each other.

In some examples, as shown in FIG. 9A, the channels 1111 on the first partition plate 111 are all via holes 1111a. In addition, the projection, of the heat conduction member 21 on the inner surface of the heat conduction substrate 1101b embedded in the opening, on the first partition plate 111 and each via hole 1111a on the first partition plate 111 avoid each other. In other words, the projection, of the heat conduction member 21 on the inner surface of the heat conduction substrate 1101b embedded in the opening, on the first partition plate 111 does not overlap each via hole 1111a on the first partition plate 111.

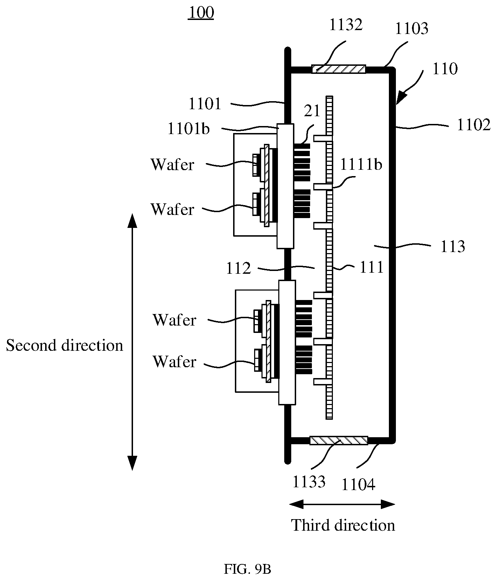

In some examples, as shown in FIG. 9B, the channels 1111 on the first partition plate 111 are all flow guiding tubes 1111b. In addition, the projection, of the heat conduction member 21 on the inner surface of the heat conduction substrate 1101b embedded in the opening, on the first partition plate 111 and each flow guiding tube 1111b on the first partition plate 111 avoid each other. In other words, the projection, of the heat conduction member 21 on the inner surface of the heat conduction substrate 1101b embedded in the opening, on the first partition plate 111 does not overlap each flow guiding tube 1111b on the first partition plate 111.

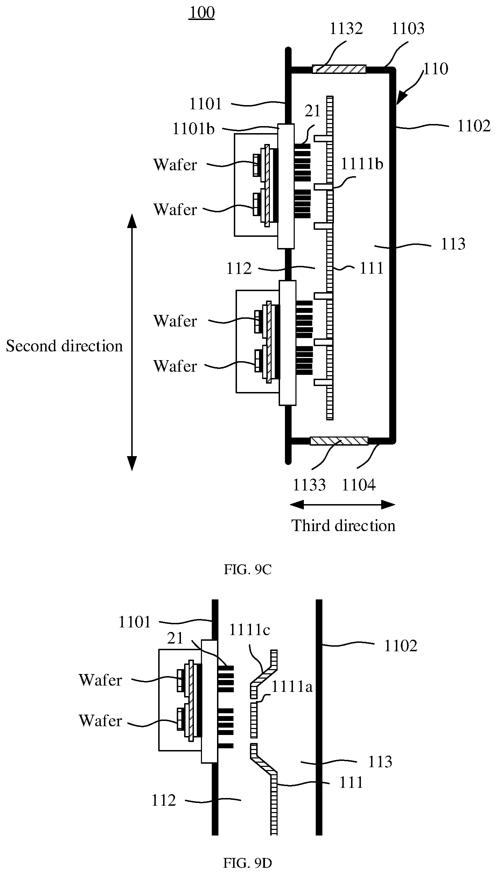

In some examples, to improve effect of supplementing the refrigerant in the liquid state in the first cavity 112, the flow guiding tube 1111b on the first partition plate 111 may fit with the heat conduction member 21. For example, as shown in FIG. 9C, the second side wall 1103 and the third side wall 1104 are opposite to each other in the gravity direction, and the second side wall 1103 is located above the third side wall 1104, that is, the third side wall 1104 is located below the second side wall 1103. The channels 1111 on the first partition plate 111 may be all flow guiding tubes 1111b. The projection, of the heat conduction member 21 on the inner surface of the heat conduction substrate 1101b embedded in the opening, on the first partition plate 111 and each flow guiding tube 1111b on the first partition plate 111 avoid each other, and a projection of a free end of each heat conduction member 21 on the second side wall 1103 partially overlaps a projection of each flow guiding tube 1111b on the second side wall 1103.

Optionally, one or more protrusion parts 1111c may be provided on the first partition plate 111. Some or all of the channels 1111 on the first partition plate 111 may be provided on the protrusion part 1111c on the first partition plate 111. This is not excessively limited in embodiments of this application. For example, FIG. 9D shows an example position relationship between the heat conduction member 21 and the via hole 1111a on the protrusion part 1111c. The via hole 1111a is provided on the protrusion part 1111c on the first partition plate 111. The projection, of the heat conduction member 21 on the inner surface of the heat conduction substrate 1101b embedded in the opening, on the first partition plate 111 and each via hole 1111a on the protrusion part 1111c avoid each other.

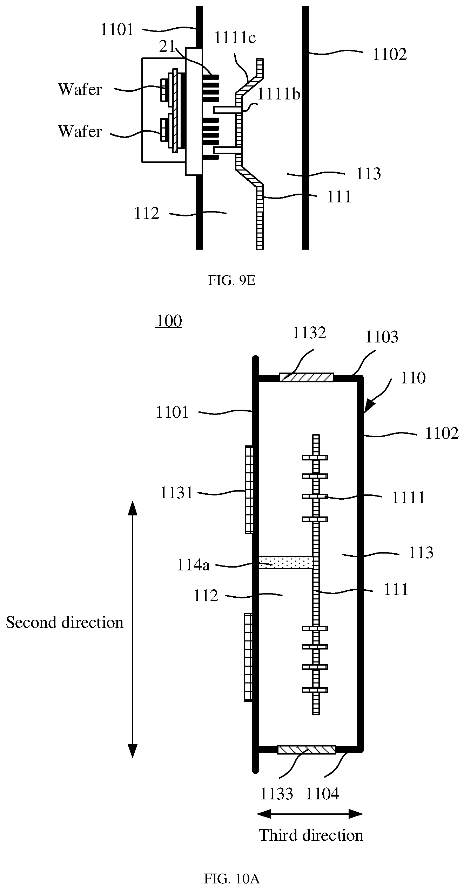

For example, FIG. 9E shows an example position relationship between the heat conduction member 21 and the via hole 1111a on the protrusion part 1111c. The jet tube 1111b is provided on the protrusion part 1111c on the first partition plate 111. The projection, of the heat conduction member 21 on the inner surface of the heat conduction substrate 1101b embedded in the opening, on the first partition plate 111 and each jet tube 1111b on the protrusion part 1111c avoid each other. Optionally, the second side wall 1103 and the third side wall 1104 are opposite to each other in the gravity direction, and the second side wall 1103 is located above the third side wall 1104, that is, the third side wall 1104 is located below the second side wall 1103. The channels 1111 on the first partition plate 111 may be all flow guiding tubes 1111b. The projection, of the heat conduction member 21 on the inner surface of the heat conduction substrate 1101b embedded in the opening, on the first partition plate 111 and each flow guiding tube 1111b on the protrusion part 1111c avoid each other, and a projection of each heat conduction member 21 on the second side wall 1103 partially overlaps a projection of each flow guiding tube 1111b on the protrusion part 1111c on the second side wall 1103.

Based on the first partition plate 111 provided in any one of the foregoing embodiments, in a possible design, a heat source is fastened to an outer surface of the first side wall 1101 of the heat dissipation apparatus 100. A plurality of heat sources are fastened to the outer surface of the first side wall 1101, and the plurality of heat sources are spaced from each other. One or more second partition plates are disposed inside a cavity between the first partition plate 111 and the first side wall 1101, and the second partition plate is configured to separate two adjacent heat sources. In other words, heat dissipation areas 1131 that are of the outer surface of the first side wall 1101 in the heat dissipation apparatus 100 and to which the heat sources are fastened are spaced from each other, and two adjacent heat dissipation areas 1131 are spaced from each other.

In a specific implementation, the second side wall 1103 and the third side wall 1104 are opposite to each other in a gravity direction, and the first side wall 1101 is located between the second side wall 1103 and the third side wall 1104. Optionally, the second side wall 1103 may be located above the third side wall 1104. Alternatively, the second side wall 1103 is located below the third side wall 1104. This is not excessively limited in embodiments.

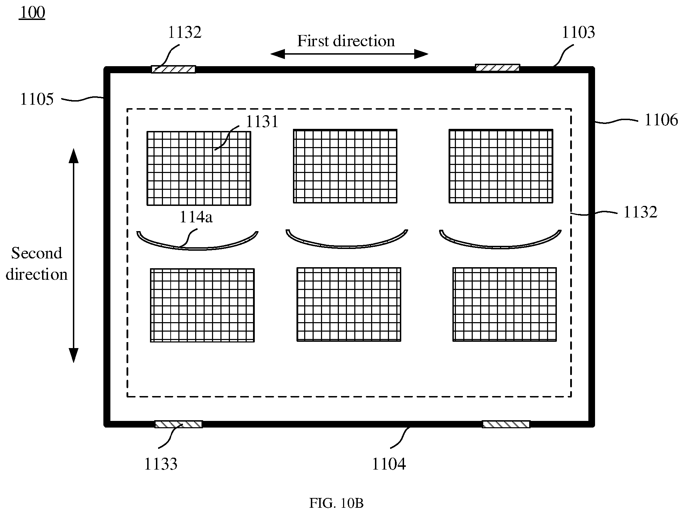

In some examples, in the heat dissipation apparatus 100, in the second partition plates disposed inside the cavity between the first partition plate 111 and the first side wall 1101, at least one second partition plate is a horizontal heat partition plate, or each second partition plate is a horizontal heat source partition plate. One surface of the horizontal heat source partition plate faces the second side wall 1103, and the other surface of the horizontal heat source partition plate faces the third side wall 1104. Refer to both FIG. 10A and FIG. 10B. The second direction is the gravity direction, and an example in which the second side wall 1103 is located above the third side wall 1104 is used. At least one horizontal heat source partition plate 114a is disposed inside the first cavity 112. One surface of the horizontal heat source partition plate 114a faces the second side wall 1103, and the other surface of the horizontal heat source partition plate 114a faces the third side wall 1104.

The plurality of heat sources fastened to the outer surface of the first side wall 1101 may include at least one group of heat sources. One group of heat sources may include at least two heat sources, and the at least two heat sources are arranged in the gravity direction. One horizontal heat source partition plate 114a is disposed between any two adjacent heat sources arranged in the gravity direction (namely, the second direction in FIG. 10A). One surface of the horizontal heat source partition plate 114a faces the second side wall 1103, and the other surface of the horizontal heat source partition plate 114a faces the third side wall 1104. For ease of description, the two adjacent heat sources arranged in the gravity direction are respectively referred to as a first heat source and a second heat source. The first heat source is located above the second heat source. The horizontal heat source partition plate 114a may isolate a bubble at the second heat source from the first heat source, so that difficulty in supplementing liquid at the first heat source due to floating of the bubble at the second heat source can be avoided. Optionally, to reduce flow resistance of the bubble, the horizontal heat source partition plate 114a may be set in a plurality of forms such as an arc shape or a V shape. Alternatively, a projection of the horizontal heat source partition plate 114a on the first side wall 1101 may be arc-shaped, V-shaped, or the like. A form of the horizontal heat source partition plate 114a is not excessively limited in this application.

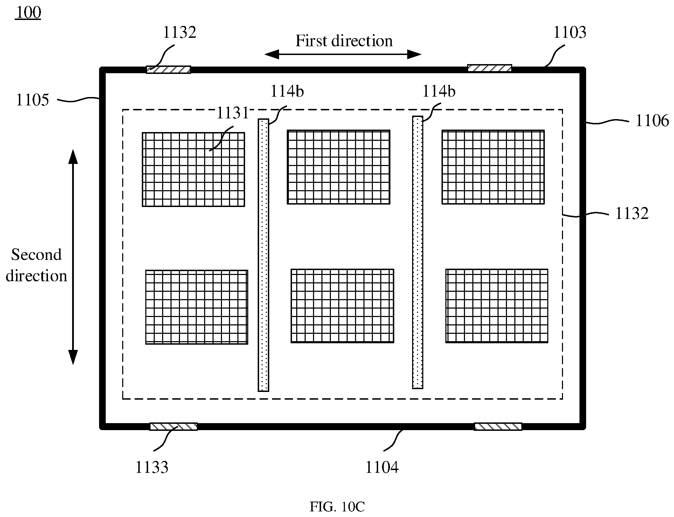

In some examples, in the heat dissipation apparatus 100, in the second partition plates disposed inside the cavity between the first partition plate 111 and the first side wall 1101, at least one second partition plate is a vertical heat partition plate, or each second partition plate is a vertical heat source partition plate. A length direction of the vertical heat source partition plate is the gravity direction. In addition, a first side wall of the vertical heat source partition plate is fastened to the first side wall 1101 of the housing 110, and a side wall that is of the vertical heat source partition plate and that is opposite to the first side wall of the vertical heat source partition plate extends toward the first partition plate 111. In this case, one face of the vertical heat source partition plate faces the fifth side wall 1105, and the other face of the vertical heat source partition plate faces the sixth side wall 1106. Refer to FIG. 10C. The second direction is the gravity direction, and an example in which the second side wall 1103 is located above the third side wall 1104 is used. A length direction of the vertical heat source partition plate 114b is the gravity direction. In addition, a first side wall of the vertical heat source partition plate 114b is fastened to the first side wall 1101 of the housing 110, and a side wall that is of the vertical heat source partition plate 114b and that is opposite to the first side wall of the vertical heat source partition plate 114b extends toward the first partition plate 111. In this case, one face of the vertical heat source partition plate 114b faces the fifth side wall 1105, and the other face of the vertical heat source partition plate 114b faces the sixth side wall 1106.

The plurality of heat sources fastened to the outer surface of the first side wall 1101 may include a plurality of groups of heat sources. The plurality of groups of heat sources may be arranged in the first direction. Each group of heat sources may include one heat source, or each group of heat sources may include at least two heat sources arranged in the gravity direction. The vertical heat source partition plate 114b may separate two adjacent groups of heat sources arranged in the first direction. Alternatively, the vertical heat source partition plate 114b separates two adjacent heat sources arranged in the first direction. The vertical heat source partition plate may separate gases generated at the two separated heat sources, to prevent bubbles generated by different heat sources from mingling with each other, affecting liquid supplement effect at each heat source.

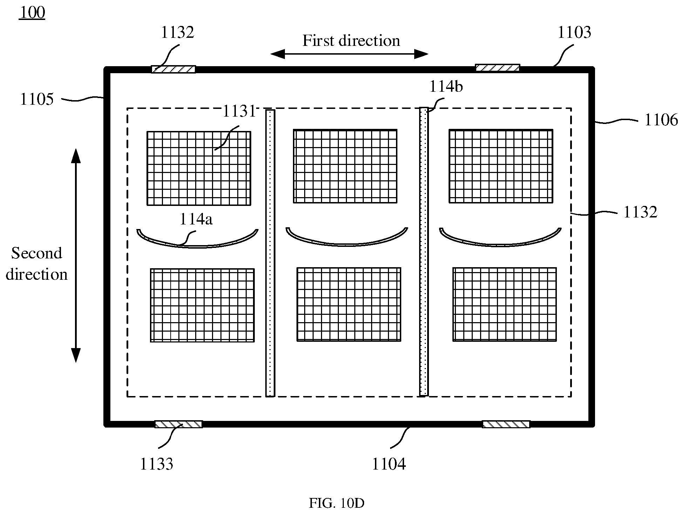

In some examples, as shown in FIG. 10D, in the heat dissipation apparatus 100, the plurality of heat sources fastened to the outer surface of the first side wall 1101 may include a plurality of groups of heat sources. The plurality of groups of heat sources include at least two heat sources, and the at least two heat sources are arranged in the gravity direction. The plurality of groups of heat sources are arranged in the first direction. In the plurality of second partition plates disposed inside the cavity between the first partition plate 111 and the first side wall 1101, some second partition plates may be horizontal heat source partition plates 114a, and some may be vertical heat source partition plates 114b. A horizontal heat source partition plate 114a is disposed between two adjacent heat sources arranged in the gravity direction (namely, the second direction in FIG. 10D). In the cavity between the first partition plate 111 and the first side wall 1101, a vertical heat source partition plate 114b is disposed between two adjacent heat sources arranged in the first direction. Such a design can prevent bubbles generated at the heat sources from mingling with each other.

Based on the first partition plate 111 provided in any one of the foregoing embodiments, in a possible design, the first side wall 1101 of the heat dissipation apparatus 100 has a plurality of openings 1131a. At least one second partition plate is disposed inside a cavity between the first partition plate 111 and the first side wall 1101, and each second partition plate is configured to separate two adjacent openings. One or more second partition plates are disposed inside the cavity between the first partition plate 111 and the first side wall 1101, and the second partition plate is configured to separate two adjacent openings 1131a. In other words, the second partition plate may separate heat conduction substrates in the two adjacent openings 1131a.

In a specific implementation, the second side wall 1103 and the third side wall 1104 are opposite to each other in a gravity direction, and the first side wall 1101 is located between the second side wall 1103 and the third side wall 1104. Optionally, the second side wall 1103 may be located above the third side wall 1104. Alternatively, the second side wall 1103 is located below the third side wall 1104. This is not excessively limited in embodiments.

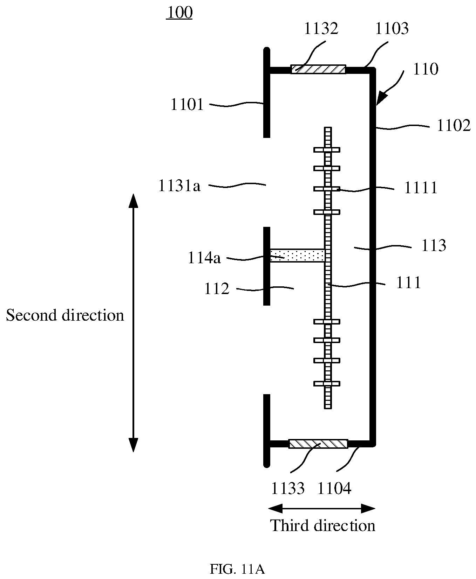

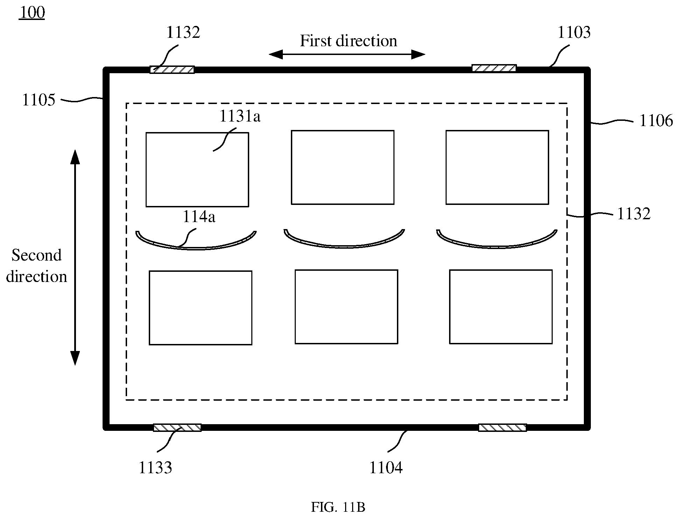

In some examples, in the heat dissipation apparatus 100, in the second partition plates disposed inside the cavity between the first partition plate 111 and the first side wall 1101, at least one second partition plate is a horizontal heat partition plate, or each second partition plate is a horizontal heat source partition plate. One surface of the horizontal heat source partition plate faces the second side wall 1103, and the other surface of the horizontal heat source partition plate faces the third side wall 1104. Refer to both FIG. 11A and FIG. 11B. The second direction is the gravity direction, and an example in which the second side wall 1103 is located above the third side wall 1104 is used. At least one horizontal heat source partition plate 114a is disposed inside the first cavity 112. One surface of the horizontal heat source partition plate 114a faces the second side wall 1103, and the other surface of the horizontal heat source partition plate 114a faces the third side wall 1104.

The plurality of openings 1131a on the first side wall 1101 include at least one group of openings 1131a. The at least one group of openings 1131a includes at least two openings 1131a, and the at least two openings 1131a are arranged in the gravity direction. One horizontal heat source partition plate 114a is disposed between two adjacent openings 1131a arranged in the gravity direction (namely, the second direction in FIG. 11A). One surface of the horizontal heat source partition plate 114a faces the second side wall 1103, and the other surface of the horizontal heat source partition plate 114a faces the third side wall 1104. For ease of description, the two adjacent openings 1131a arranged in the gravity direction are respectively referred to as a first opening 1131a and a second opening 1131a. The first opening 1131a is located above the second opening 1131a. The horizontal heat source partition plate 114a may isolate a bubble at a heat conduction substrate in the second opening 1131a from the first opening 1131a, so that difficulty in supplementing liquid at the first opening 1131a due to floating of the bubble at the heat conduction substrate in the second opening 1131a can be avoided. Optionally, to reduce flow resistance of the bubble, the horizontal heat source partition plate 114a may be set in a plurality of forms such as an arc shape or a V shape. Alternatively, a projection of the horizontal heat source partition plate 114a on the first side wall 1101 may be arc-shaped, V-shaped, or the like. A form of the horizontal heat source partition plate 114a is not excessively limited in this application.

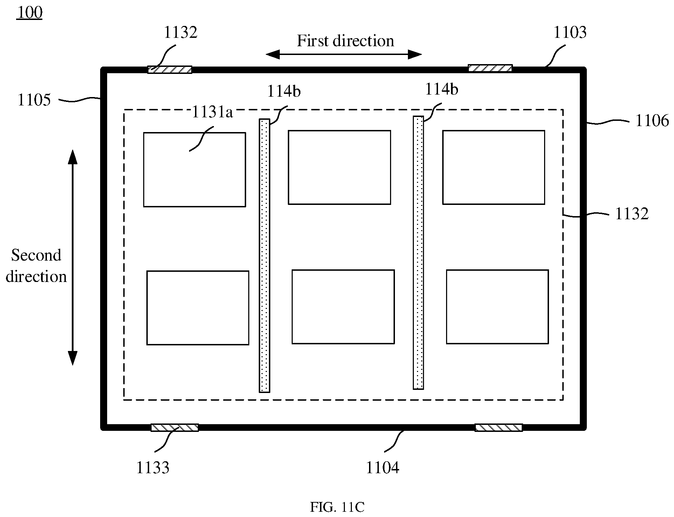

In some examples, in the heat dissipation apparatus 100, in the second partition plates disposed inside the cavity between the first partition plate 111 and the first side wall 1101, at least one second partition plate is a vertical heat partition plate, or each second partition plate is a vertical heat source partition plate. A length direction of the vertical heat source partition plate is the gravity direction. In addition, a first side wall of the vertical heat source partition plate is fastened to the first side wall 1101 of the housing 110, and a side wall that is of the vertical heat source partition plate and that is opposite to the first side wall of the vertical heat source partition plate extends toward the first partition plate 111. In this case, one face of the vertical heat source partition plate faces the fifth side wall 1105, and the other face of the vertical heat source partition plate faces the sixth side wall 1106. Refer to FIG. 11C. The second direction is the gravity direction, and an example in which the second side wall 1103 is located above the third side wall 1104 is used. A length direction of the vertical heat source partition plate 114b is the gravity direction. In addition, a first side wall of the vertical heat source partition plate 114b is fastened to the first side wall 1101 of the housing 110, and a side wall that is of the vertical heat source partition plate 114b and that is opposite to the first side wall of the vertical heat source partition plate 114b extends toward the first partition plate 111. In this case, one face of the vertical heat source partition plate 114b faces the fifth side wall 1105, and the other face of the vertical heat source partition plate 114b faces the sixth side wall 1106.

The plurality of openings 1131a on the first side wall 1101 may include a plurality of groups of openings 1131a. The plurality of groups of openings 1131a may be arranged in the first direction. Each group of openings 1131a may include one opening 1131a, or each group of openings 1131a may include at least two openings 1131a arranged in the gravity direction. The vertical heat source partition plate 114b may separate two adjacent groups of openings 1131a arranged in the first direction. Alternatively, the vertical heat source partition plate 114b separates two adjacent openings 1131a arranged in the first direction. The vertical heat source partition plate may separate gases generated at heat conduction substrates in the two separated openings 1131a, to prevent bubbles generated by the heat conduction substrates in different openings 1131a from mingling with each other, affecting liquid supplement effect at the heat conduction substrate in each opening 1131a.

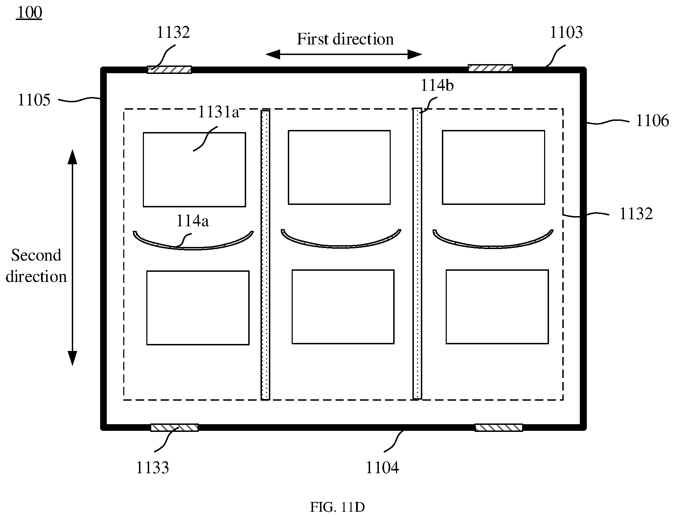

In some examples, as shown in FIG. 11D, in the heat dissipation apparatus 100, the plurality of openings 1131a fastened to the outer surface of the first side wall 1101 may include a plurality of groups of openings 1131a. The plurality of groups of openings 1131a include at least two openings 1131a, and the at least two openings 1131a are arranged in the gravity direction. The plurality of groups of openings 1131a are arranged in the first direction. In the plurality of second partition plates disposed inside the cavity between the first partition plate 111 and the first side wall 1101, some second partition plates may be horizontal heat source partition plates 114a, and some may be vertical heat source partition plates 114b. A horizontal heat source partition plate 114a is disposed between two adjacent openings 1131a arranged in the gravity direction (namely, the second direction in FIG. 10D). In the cavity between the first partition plate 111 and the first side wall 1101, a vertical heat source partition plate 114b is disposed between two adjacent openings 1131a arranged in the first direction. Such a design can prevent bubbles generated at the heat sources from mingling with each other.

Based on the heat dissipation apparatus 100 provided in any one of the foregoing designs and the first partition plate 111 provided in any one of the foregoing embodiments, the second side wall 1103 and the third side wall 1104 are opposite to each other in the gravity direction, and the first side wall 1101 is located between the second side wall 1103 and the third side wall 1104.

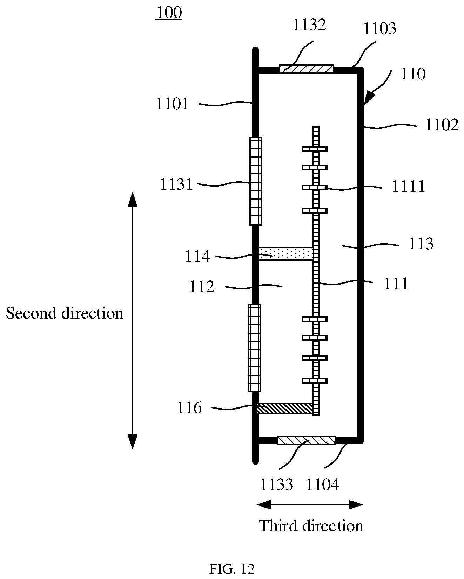

In some examples, the heat dissipation apparatus 100 further includes a third partition plate. One face of the third partition plate faces the second side wall 1103, and the other face of the third partition plate faces the third side wall 1104. An end that is of the first partition plate 111 and that is away from the air outlet 1132 is connected to the first side wall 1101 of the housing by using the third partition plate. Optionally, the second side wall 1103 may be located above the third side wall 1104. Alternatively, the second side wall 1103 is located below the third side wall 1104. In a specific implementation, as shown in FIG. 12, the second side wall 1103 and the third side wall 1104 are opposite to each other in the gravity direction. In other words, the second direction in FIG. 12 is the gravity direction. The second side wall 1103 is located above the third side wall 1104. The heat dissipation apparatus 100 further includes a third partition plate 116. One face of the third partition plate 116 faces the second side wall 1103, and the other face of the third partition plate 116 faces the third side wall 1104. The end that is of the first partition plate 111 and that is away from the air outlet 1132 is connected to the first side wall 1101 of the housing by using the third partition plate 116. In such a design, the third side plate 116 may be configured to block an area between the first side wall 1101 and the first partition plate 111, so that a speed at which liquid in the second cavity 113 flows into the first cavity 112 through the channel 1111 can be increased. This improves impact effect of the liquid flowing into the first cavity 112, strengthens boiling heat transfer, and improves heat dissipation effect.

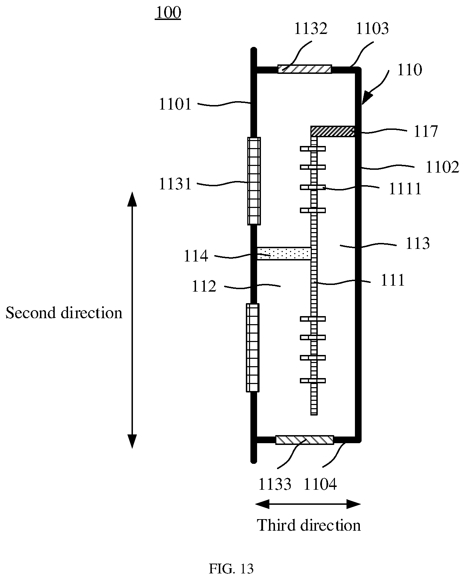

In some examples, the heat dissipation apparatus 100 further includes a fourth partition plate. One face of the fourth partition plate faces the second side wall 1103, and the other face of the fourth partition plate faces the third side wall 1104. An end that is of the first partition plate 111 and that is close to the air outlet 1132 is connected to a side wall opposite to the first side wall 1101 by using the fourth partition plate. Optionally, the second side wall 1103 may be located above the third side wall 1104. Alternatively, the second side wall 1103 is located below the third side wall 1104. In a specific implementation, as shown in FIG. 13, the second side wall 1103 and the third side wall 1104 are opposite to each other in the gravity direction. In other words, the second direction in FIG. 13 is the gravity direction. The second side wall 1103 is located above the third side wall 1104. The side wall opposite to the first side wall 1101 is denoted as the fourth side wall 1102. The heat dissipation apparatus 100 further includes a fourth partition plate 117. One face of the fourth partition plate 117 faces the second side wall 1103, and the other face of the fourth partition plate 117 faces the third side wall 1104. The end that is of the first partition plate 111 and that is close to the air outlet 1132 is connected to the first side wall 1101 of the housing by using the fourth partition plate 117. In such a design, the fourth partition plate 117 may be configured to block an area between the fourth side wall 1102 and the first partition plate 111, so that a speed at which liquid in the second cavity 113 flows into the first cavity 112 through the channel 1111 can be increased. This improves impact effect of the liquid flowing into the first cavity 112, strengthens boiling heat transfer, and improves heat dissipation effect.

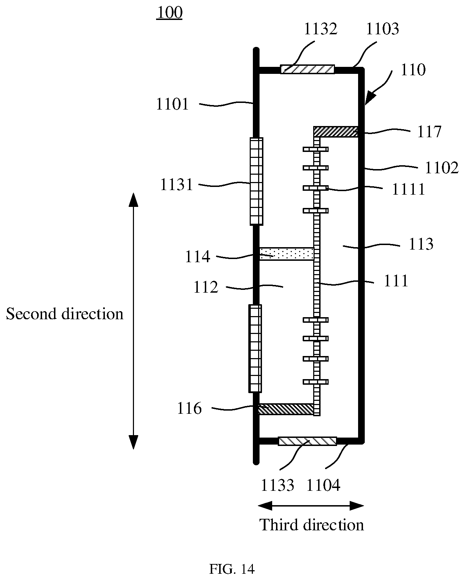

In some examples, the heat dissipation apparatus 100 may include the third partition plate and the fourth partition plate. In a specific implementation, as shown in FIG. 14, the second side wall 1103 and the third side wall 1104 are opposite to each other in the gravity direction. In other words, the second direction in FIG. 14 is the gravity direction. The second side wall 1103 is located above the third side wall 1104. The side wall opposite to the first side wall 1101 is denoted as the fourth side wall 1102. The heat dissipation apparatus 100 further includes the third partition plate 116 and the fourth partition plate 117. One face of the third partition plate 116 faces the second side wall 1103, and the other face of the third partition plate 116 faces the third side wall 1104. The end that is of the first partition plate 111 and that is away from the air outlet 1132 is connected to the first side wall 1101 of the housing by using the third partition plate 116. One face of the fourth partition plate 117 faces the second side wall 1103, and the other face of the fourth partition plate 117 faces the third side wall 1104. The end that is of the first partition plate 111 and that is close to the air outlet 1132 is connected to the first side wall 1101 of the housing by using the fourth partition plate 117. The third side plate 116 may be configured to block an area between the first side wall 1101 and the first partition plate 111. The fourth partition plate 117 may be configured to block an area between the fourth side wall 1102 and the first partition plate 111. Such a design can increase a speed at which liquid in the second cavity 113 flows into the first cavity 112 through the channel 1111. This improves impact effect of the liquid flowing into the first cavity 112, strengthens boiling heat transfer, and improves heat dissipation effect.

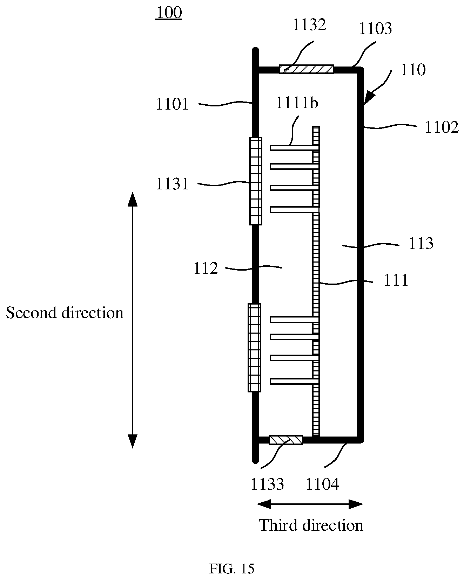

In some examples, the second side wall 1103 and the third side wall 1104 are opposite to each other in the gravity direction, and the second side wall 1103 is located above the third side wall 1104, that is, the third side wall 1104 is located below the second side wall 1103. In a specific implementation, as shown in FIG. 15, the first partition plate 111 is connected to or abuts against the third side wall 1104, and the liquid inlet 1133 is provided at an area that is of the third side wall 1104 and that is located between the first side wall 1101 and the first partition plate 111. Such a design can increase a speed at which the liquid refrigerant flows to the second side wall 1103, to form flow boiling effect and strengthen heat dissipation.

An embodiment of this application further provides a power device. The power device may include at least one power module and the heat dissipation apparatus 100 in any one of the foregoing embodiments. An outer surface of a first side wall 1101 of a housing 110 of the heat dissipation apparatus 100 may be used for fastening the power module. Alternatively, a heat conduction substrate in an opening of a first side wall 1101 may carry the power module.

Optionally, the power device may further include a condenser, configured to liquefy a refrigerant in a gas state into the refrigerant in a liquid state. The condenser may be separately coupled to an air outlet 1132 and a liquid inlet 1133 of the heat dissipation apparatus 100.

Optionally, a second side wall 1103 on which the air outlet 1132 is located and a third side wall 1104 on which the liquid inlet 1133 is located are opposite to each other in a gravity direction, and the second side wall 1103 is located above the third side wall 1104. In the power device, the condenser is located at the top of the heat dissipation apparatus 100 in the gravity direction. The condenser is coupled to the air outlet 1132 and the liquid inlet 1133 of the heat dissipation apparatus, and is configured to convert the refrigerant in the gas state into the refrigerant in the liquid state. In such a design, the power device may not need to use a driving device, for example, a pump or a motor, to drive liquid to flow inside the heat dissipation apparatus 100 or a gas to flow inside the heat dissipation apparatus 100.

An embodiment of this application further provides a photovoltaic system, including a panel and the foregoing power device. The panel is configured to convert solar energy into electric energy, and the power device is configured to convert a current and/or a voltage from the panel.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A heat dissipation apparatus (100), comprising a housing (110), wherein a heat source is fastened to an outer surface of a first side wall (1101) of the housing (110), or the first side wall (1101) of the housing (110) has an opening (1131a) and the heat source is fastened to an outer surface of a heat conduction substrate (1101b) embedded in the opening (1131a); and an air outlet (1132) is provided on a second side wall (1103) of the housing (110), and a liquid inlet (1133) is provided on a third side wall (1104) of the housing (110); and
a first partition plate (111) is disposed inside the housing (110), one face of the first partition plate (111) faces the first side wall (1101), the other face of the first partition plate (111) is away from the first side wall (1101), the first partition plate (111) partitions the first housing (110) into a first cavity (112) and a second cavity (113), one or more channels (1111) are provided on the first partition plate (111), each channel (1111) is configured to communicate the first cavity (112) with the second cavity (113), and an end that is of each channel (1111) and that is close to the first side wall (1101) faces an area that is of the first side wall (1101) and to which the heat source is fastened or faces the heat conduction substrate (1101b).

2. The heat dissipation apparatus (100) according to claim 1, wherein an inner peripheral wall of the opening (1131a) of the first side wall (1101) is in a sealing fit with an outer peripheral wall of the heat conduction substrate (1101b).

3. The heat dissipation apparatus (100) according to claim 1 or 2, wherein a side that is of the first partition plate (111) and that is close to the first side wall (1101) has one or more protrusion parts (1111c), and at least one channel (1111) is provided on at least one protrusion part (1111c).

4. The heat dissipation apparatus (100) according to any one of claims 1 to 3, wherein the heat source comprises at least one wafer, and a projection of each wafer on the first partition plate (111) and each channel (1111) avoid each other.

5. The heat dissipation apparatus (100) according to any one of claims 1 to 4, wherein a plurality of heat sources are fastened to the outer surface of the first side wall (1101), and the plurality of heat sources are spaced from each other; and
one or more second partition plates (114a, 114b) are disposed inside a cavity between the first partition plate (111) and the first side wall (1101), and the second partition plate (114a, 114b) is configured to separate two adjacent heat sources.

6. The heat dissipation apparatus (100) according to any one of claims 1 to 4, wherein the first side wall (1101) has a plurality of openings (1131a); and
at least one second partition plate (114a, 114b) is disposed inside a cavity between the first partition plate (111) and the first side wall (1101), and each second partition plate (114a, 114b) is configured to separate two adjacent openings (1131a).

7. The heat dissipation apparatus (100) according to any one of claims 1 to 6, wherein the second side wall (1103) and the third side wall (1104) are opposite to each other in a gravity direction, and the first side wall (1101) is located between the second side wall (1103) and the third side wall (1104).

8. The heat dissipation apparatus (100) according to claim 7, wherein one surface of the at least one second partition plate faces the second side wall (1103), and the other surface of the at least one second partition plate faces the third side wall (1104).

9. The heat dissipation apparatus (100) according to claim 7 or 8, wherein a length direction of the at least one second partition plate is the gravity direction, a side wall of the at least one second partition plate (114) is fastened to the first side wall (1101), and a side wall opposite to the side wall extends toward the first partition plate (111).

10. The heat dissipation apparatus (100) according to any one of claims 7 to 9, wherein an end that is of the first partition plate (111) and that is away from the air outlet (1132) is connected to the first side wall (1101) by using a third partition plate (116), one face of the third partition plate (116) faces the second side wall (1103), and the other face of the third partition plate (116) faces the third side wall (1104).

11. The heat dissipation apparatus (100) according to any one of claims 7 to 10, wherein an end that is of the first partition plate (111) and that is close to the air outlet (1132) is connected to a side wall opposite to the first side wall (1101) by using a fourth partition plate (117), one face of the fourth partition plate (117) faces the second side wall (1103), and the other face of the fourth partition plate (117) faces the third side wall (1104).

12. The heat dissipation apparatus (100) according to any one of claims 1 to 11, wherein the at least one channel (1111) is a via hole (1111a).

13. The heat dissipation apparatus (100) according to any one of claims 1 to 12, wherein the at least one channel (1111) is a flow guiding tube (1111b), and the flow guiding tube (1111b) is disposed on the side that is of the first partition plate (111) and that faces the first side wall (1101).

14. The heat dissipation apparatus (100) according to claim 13, wherein a heat conduction member (21) extending toward the inside of the first cavity (112) is provided on an inner surface of the heat conduction substrate (1101b), and a projection of the heat conduction member (21) on the first partition plate (111) and each channel (1111) avoid each other.

15. The heat dissipation apparatus (100) according to claim 14, wherein a projection of a free end of the heat conduction member (21) on the second side wall (1103) partially overlaps a projection of the flow guiding tube (1111b) on the second side wall (1103).

16. The heat dissipation apparatus (100) according to any one of claims 7 to 15, wherein the third side wall (1104) is located below the second side wall (1103) in the gravity direction; and
the first partition plate (111) is connected to or abuts against the third side wall (1104), and the liquid inlet (1133) is provided at an area that is of the third side wall (1104) and that is located between the first side wall (1101) and the first partition plate (111).

17. A power device, comprising at least one power module and the heat dissipation apparatus (100) according to any one of claims 1 to 16, wherein the heat dissipation apparatus (100) is configured to dissipate heat for each power module.

18. A photovoltaic system, comprising a panel and the power device according to claim 17, wherein the panel is configured to convert solar energy into electric energy, and the power device is configured to convert a current and/or a voltage from the panel.
